**Europäisches Patentamt**

**European Patent Office**

**Office européen des brevets**

(19)

(11) Veröffentlichungsnummer: **0 123 732**
A2

(12) # EUROPÄISCHE PATENTANMELDUNG

(21) Anmeldenummer: **83113052.1**

(51) Int. Cl.³: **H 05 K 13/04**

(22) Anmeldetag: **23.12.83**

(30) Priorität: **31.03.83 DE 3311792**

(43) Veröffentlichungstag der Anmeldung: **07.11.84**
**Patentblatt 84/45**

(84) Benannte Vertragsstaaten: **FR GB IT**

(71) Anmelder: **Blaupunkt-Werke GmbH,**
**Robert-Bosch-Strasse 200, D-3200 Hildesheim (DE)**

(72) Erfinder: **Glatzel, Werner, Breslauer Strasse 26 Ot**
**Ottbergen, D-3209 Schellerten (DE)**

(74) Vertreter: **Eilers, Norbert, Dipl.-Phys., Blaupunkt-Werke**
**GmbH Robert-Bosch-Strasse 200, D-3200 Hildesheim**
**(DE)**

(54) Vorrichtung zum Richten von Anschlussdrähten elektrischer Bauelemente.

(57) Zum Richten von Anschlußdrähten elektrischer Bauelemente für gedruckte Schaltungen wird in einer Vorrichtung jeweils ein in Verlägerung der Sollachse des Anschlußdrahtes angeordneter, um die Sollachse drehbar gelagerter Richtkörper vorgesehen, der eine in der Ebene der Rotationsachse des Richtkörpers angeordnete Nut aufweist. Der Anschlußdraht des Bauelementes wird mittels eines Führungsteils kurzzeitig in die Nut des rotierenden Richtkörpers eingetaucht.

**BLAUPUNKT-WERKE GMBH** 32 HILDESHEIM, Robert-Bosch-Straße 200

PLI-Hi Pieper/TEX2-Od/3          - 1 -                    17.3.83
                                                          R.Nr. 1774

Die Erfindung betrifft eine Vorrichtung zum Richten von Anschlußdrähten elektrischer Bauelemente nach der Gattung des Hauptanspruchs.

Die parallel ausgerichteten Anschlußdrähte von üblichen elektrischen Bauelementen weisen im Anlieferungszustand nicht die für eine automatische Bestückung von elektrischen Leiterplatten erforderlichen engen Toleranzen auf. So werden z. B. bei einer automatischen Bestückung die parallel ausgerichteten Anschlußdrähte der aufzubringenden Bauelemente mittels einer Greifvorrichtung von oben in die Bohrungen der zu bestückenden Leiterplatte eingeführt. Um die Bohrungen sicher zu treffen, muß die Greifvorrichtung, welche die Anschlußdrähte zentriert und festhält, möglichst nahe an die Bohrungen herangeführt werden. Bei elektrischen Bauelementen mit größeren und/oder blockförmigen Abmessungen lassen sich die Anschlußdrähte ab einer bestimmten Bestückungsdichte nicht mit einer Greifvorrichtung in die Bohrungen der Leiterplatte einbringen. Derartige Bauelemente machen daher eine zeitaufwendige manuelle Bestückung erforderlich.

Der Erfindung liegt die Aufgabe zugrunde, eine Vorrichtung zu erstellen, mit welcher Anschlußdrähte von üblichen, für elektrische Schaltungen vorgesehenen Bauelementen derart ihrer Sollage angenähert werden können, daß sie ein problemloses Einfügen in ihnen zugeordnete Bohrungen einer Schaltplatte gestatten.

Diese Aufgabe wird bei einer gattungsgemäßen Vorrichtung durch die kennzeichnenden Merkmale des Anspruchs 1 gelöst.

...

**BLAUPUNKT-WERKE GMBH** 34 HILDESHEIM, Robert-Bosch-Straße 200

PLI-Hi Pieper/TEX2-Od/3          - 2 -                    17.3.83
                                                         R.Nr. 1774

Durch die in den Unteransprüchen aufgeführten Maßnahmen sind vorteilhafte Weiterbildungen der Vorrichtung möglich. So lassen sich mit den in den Ansprüchen 2 - 4 beschriebenen Ausbildungen der Nut die Anschlußdrähte der Bauelemente sehr präzise ausrichten. Eine Ausbildung der Vorrichtung nach Anspruch 5 ermöglicht ein gleichzeitiges Ausrichten mehrerer Anschlußdrähte eines Bauteils. Ein besonders einfacher Aufbau der Vorrichtung ist nach den in den Ansprüchen 6 und 7 angeführten Maßnahmen möglich.

Die mit der Erfindung erzielten Vorteile bestehen insbesondere darin, daß die Enden der Anschlußdrähte von elektrischen Bauelementen für gedruckte Schaltungen einfach und schnell in ihre Sollage positioniert werden können. Dadurch wird eine Bestückung mit derartigen Bauelementen wesentlich vereinfacht. Zudem läßt sich die Vorrichtung in vorteilhafter Weise in einen Bestückungsautomaten integrieren.

Ein Ausführungsbeispiel der Erfindung ist in der Zeichnung dargestellt und wird im folgenden näher beschrieben.

Es zeigen:

Figur 1     die Vorderansicht,

Figur 2     eine Seitenansicht einer Vorrichtung zum Richten von Anschlußdrähten von elektrischen Bauelementen,

Figur 3     den Kopfteil eines Richtkörpers in Seitenansicht,

Figur 4     in teilgeschnittener Seitenansicht,

...

Figur 5      in Draufsicht und

Figur 6 - 8 das Zusammenwirken von Anschlußdraht und Richtkörper


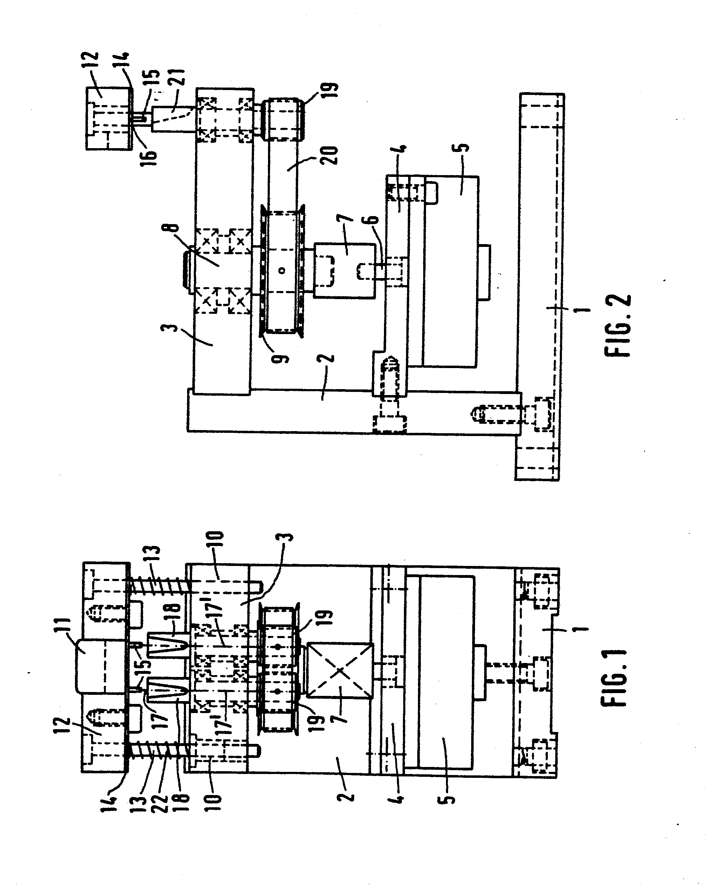

Auf einer waagerecht angeordneten, rechteckförmigen Grundplatte 1 nach Figur 1 und 2 ist eine senkrecht angeordnete, rechteckförmige Rückwand 2 befestigt. Am oberen Ende der Rückwand 2 ist eine sich nach vorn über die Grundplatte 1 erstreckende und parallel zu dieser angeordnete quaderförmig ausgebildete Lagerplatte 3 befestigt. Zwischen der Grundplatte 1 und der Lagerplatte 3 ist eine parallel zur Grundplatte 1 angeordnete Befestigungsplatte 4 für einen Elektromotor 5 vorgesehen, dessen Antriebswelle 6 durch eine Bohrung der Befestigungsplatte 4 senkrecht nach oben hindurchragt. Die Antriebswelle 6 des Motors 5 ist über ein Kupplungsteil 7 mit einer drehbar in der Lagerplatte 3 gelagerten und axial zur Antriebswelle 6 angeordneten Welle 8 versehen, auf deren unterem Teil eine Riemenscheibe 9 befestigt ist. Der vordere Abschnitt der Lagerplatte 3 ist mit zwei als Gleitlager ausgebildeten, senkrecht angeordneten Durchgangsbohrungen 10 versehen. Ein sich über die Breite der Lagerplatte 3 erstreckendes, zur Aufnahme eines elektrischen Bauelementes 11 vorgesehenes Führungsteil 12 ist mit senkrecht nach unten gerichteten, in den Durchgangsbohrungen 10 gelagerten Führungsstangen 13 versehen, welche als Parallelführung dienen und ein senkrechtes Absenken des Führungsteils 12 und damit des elektrischen Bauelementes 11 gestatten. Das Führungsteil 12 ist mit einer waagerecht angeordneten Bodenplatte 14 versehen, welche den Anschlußdrähten 15 zugeordnete Bohrungen 16 aufweist. Die beiden Anschlußdrähte 15 des im Führungsteil 12 formschlüssig gelagerten elektrischen Bauelementes 11 ragen senkrecht nach unten gerichtet durch die Bohrungen 16 der Boden-

...

**BLAUPUNKT-WERKE GMBH** 32 HILDESHEIM, Robert-Bosch-Straße 200

PLI-Hi Pieper/TEX2-Od/3　　　　　− 4 −　　　　　　　　17.3.83
　　　　　　　　　　　　　　　　　　　　　　　　　　　R.Nr. 1774

platte 14 hindurch. In Verlängerung der vorgegebenen Soll-Achse 17 jedes Anschlußdrahtes 15 ist jeweils ein in der Lagerplatte 3 um die Soll-Achse 17 drehbar gelagerter Richtkörper 18 vorgesehen, wobei die Soll-Achse 17

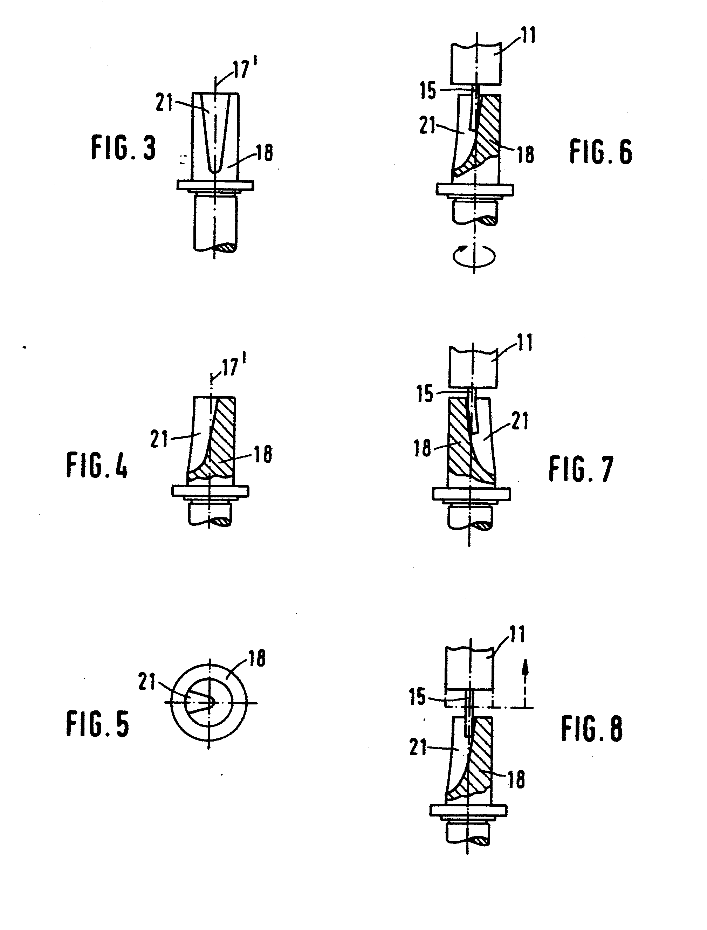

der Rotationsachse 17' des Richtkörpers 18 entspricht. Unten aus der Lagerplatte 3 herausragende Enden der Richtkörper 18 sind jeweils mit Riemenscheiben 19 versehen, die über einen Treibriemen 20 mit der Riemenscheibe 19 in Wirkverbindung stehen. Die oben aus der Lagerplatte 3 herausragenden Enden der Richtkörper 18 sind zylinderförmig ausgebildet. Sie sind nach Figur 3 bis 5 mit einer in der Ebene der Rotationsachse 17' angeordneten Nut 21 versehen, die zur Rotationsachse 17' geneigt ist und deren Tiefe sich an der Stirnseite des Richtkörpers 18 bis über dessen Rotationsachse 17' erstreckt und mit zunehmender Entfernung von der Stirnseite nach außen verlaufend abnimmt. Die Nut 21 weist einen sich nach außen V-förmigen erweiternden Querschnitt und ausgehend von der Stirnseite, einen nach außen zunehmend gekrümmten Verlauf auf.


Zum Richten der Anschlußdrähte 15 wird das elektrische Bauelement 11 zusammen mit dem Führungsteil 12 durch äußere Krafteinwirkung senkrecht abgesenkt. Dabei werden die Enden der Anschlußdrähte 15 von den Nuten 21 der rotierenden Richtkörper 18 erfaßt und aufgenommen. Bei einem überwiegend in die Nut 21 eingetauchten Anschlußdraht 15 wird das Drahtende des Anschlußdrahtes 15 aufgrund der schräg verlaufenden Nut 21 gemäß Figur 6 und 7 umlaufend und zentrisch um seine Soll-Lage gebogen. Das Drahtende führt dabei eine Taumelbewegung aus. Durch ein anschließendes senkrechtes Anheben des Führungsteils 12 und ein damit verbundenes Herausziehen des

...

**BLAUPUNKT-WERKE GMBH** 32 HILDESHEIM, Robert-Bosch-Straße 200

PLI-Hi Pieper/TEX2-Od/3          - 5 -                    17.3.83
                                                          R.Nr. 1774

Anschlußdrahtes 15 aus der Nut 21 vermindert sich der wirksame Radius dieser Taumelbewegung kontuinuierlich, bis der Anschlußdraht 15 seine vorgegebene Soll-Lage nach Figur 8 erreicht hat.

Bei der Ausführung nach Figur 1 und 2 wird das Bauelement 11 zusammen mit dem Führungsteil 12 gegen die Federkraft von auf den Führungsstangen 13 angeordneten Schraubenfedern 22 abgesenkt, welche das Führungsteil 12 anschließend in seine Ruhelage zurückführen.

Als Führungsteil kann auch ein gesteuerter Greifarm eines Bestückungsautomaten dienen.

Die für das Ausrichten der Anschlußdrähte 15 erforderliche Zeit ist von der Drehzahl der Richtkörper abhängig. Als besonders vorteilhaft hat sich eine Drehzahl von n = 3 000 Umdrehungen/min erwiesen.

. . .

Vorrichtung zum Richten von Anschlußdrähten elektrischer Bauelemente


Patentansprüche


1.  Vorrichtung zum Richten von Anschlußdrähten elektrischer Bauelemente, welche zur Bestückung elektrischer Schaltungsanordnungen, insbesondere gedruckter Schaltungen vorgesehen sind, dadurch gekennzeichnet, daß ein das Bauelement (11) aufnehmendes Führungsteil (12) und mindestens ein in Verlängerung der vorgegebenen Soll-Achse (17) des zu richtenden Anschlußdrahtes (15) um die Achse (17, 17') drehbar gelagerter Richtkörper (18) vorgesehen sind und daß das Führungsteil (12) oder der Richtkörper (18) derart in Achsrichtung des Anschlußdrahtes (15) verschiebbar gelagert ist, daß das Drahtende des Anschlußdrahtes (15) in eine Nut (21) des über Antriebsmittel (9, 19, 20) in eine Drehbewegung versetzbaren Richtkörpers (18) eintauchbar ist.


2.  Vorrichtung zum Richten von Anschlußdrähten nach Anspruch 1, dadurch gekennzeichnet, daß die im Richtkörper (18) vorgesehene Nut (21) in der Ebene der Rotationsachse (17') des Richtkörpers (18) und zur Rotationsachse (17') geneigt angeordnet ist und daß die Nut (21) derart bemessen ist, daß bei rotierendem Richtkörper (18) ein Anschluß-


. . .

draht (15) im eingetauchten Zustand zentrisch um seine Sollage gebogen wird und daß sich der wirksame Radius dieser Taumelbewegung beim Herausziehen des Anschlußdrahtes (15) kontinuierlich vermindert, bis der Anschlußdraht (15) seine Sollage erreicht.

3. Vorrichtung zum Richten von Anschlußdrähten nach Anspruch 1 oder Anspruch 2, dadurch gekennzeichnet, daß die Nut (21) einen sich nach außen V-förmig erweiternden Querschnitt aufweist, daß sich ihre Tiefe an der Stirnseite des Richtkörpers (18) bis über dessen Rotationsachse (17') erstreckt und daß die Tiefe mit zunehmender Entfernung von der Stirnseite nach außen verlaufend abnimmt.

4. Vorrichtung zum Richten von Anschlußdrähten nach Anspruch 3, dadurch gekennzeichnet, daß der Verlauf der Nut (21) gekrümmt ist.

5. Vorrichtung zum Richten von Anschlußdrähten nach Anspruch 1 - 4, dadurch gekennzeichnet, daß bei Bauelementen (11) mit mehreren Anschlußdrähten jedem Anschlußdraht (15) ein Richtkörper (18) zugeordnet ist, daß die Richtkörper (18) achsparallel angeordnet und über die Antriebsmittel (9, 19, 20) gemeinsam antreibbar sind.

6. Vorrichtung zum Richten von Anschlußdrähten nach Anspruch 1 - 5, dadurch gekennzeichnet, daß die Richtkörper (18) in einer waagerecht

. . .

0123732

angeordneten Lagerplatte (3) derart gelagert sind, daß sie mit ihren Stirnseiten senkrecht nach oben aus der Lagerplatte (3) herausragen und daß das über den Richtkörpern angeordnete Führungsteil (12) mittels einer Parallelführung (10, 13) senkrecht absenkbar ist.

7. Vorrichtung zum Richten von Anschlußdrähten nach Anspruch 6, dadurch gekennzeichnet, daß das Führungsteil (12) mit einer waagerecht angeordneten Bodenplatte (14) versehen ist, welche den Anschlußdrähten (15) des Bauelementes (11) zugeordnete Bohrungen (16) aufweist.

8. Vorrichtung zum Richten von Anschlußdrähten nach Anspruch 1, dadurch gekennzeichnet, daß als Führungsteil (12) ein gesteuerter Greifarm eines Bestückungsautomaten vorgesehen ist.

9. Verfahren zum Richten von Anschlußdrähten elektrischer Bauelemente, welche zur Bestückung elektrischer Schaltungsanordnungen bereit gehalten werden, dadurch gekennzeichnet, daß jeder Anschlußdraht während des Richtens in einer in der Sollachse des zu richtenden Anschlußdrahtes liegende Nut eines in Drehbewegung um diese Sollachse versetzbaren Richtkörpers relativ zu dem Richtkörper bewegt wird.

...

0123732

n.nr. 1114

FIG. 2

FIG. 1

FIG. 3

FIG. 4

FIG. 5

FIG. 6

FIG. 7

FIG. 8